# EUROPÄISCHE PATENTSCHRIFT

(11) **EP 2 869 963 B1**
(45) Veröffentlichungstag und Bekanntmachung des Hinweises auf die Patenterteilung: **28.09.2016**
(21) Anmeldenummer: 13723777.2
(22) Anmeldetag: 17.05.2013
(51) Int. Cl.: B23K 26/08, B23K 37/02, B23K 26/067, B23K 26/073

(54) **VORRICHTUNG UND VERFAHREN ZUR LASERBEARBEITUNG GROSSFLÄCHIGER SUBSTRATE UNTER VERWENDUNG VON MINDESTENS ZWEI BRÜCKEN**
DEVICE FOR AND METHOD OF LASER PROCESSING OF LARGE-SCALE SUBSTRATES USING AT LEAST TWO PORTALS
DISPOSITIF ET PROCÉDÉ DE TRAITEMENT PAR LASER DE SUBSTRATS DE GRANDE TAILLE UTILISANT AU MOINS DEUX PORTIQUES

(30) Priorität: 04.07.2012 EP 12174902
(43) Veröffentlichungstag der Anmeldung: 13.05.2015
(73) Patentinhaber: Saint-Gobain Glass France, 92400 Courbevoie (FR)
(72) Erfinder: YEH, Li-Ya, 52511 Geilenkirchen (DE)
(74) Vertreter: Gebauer, Dieter Edmund
(86) Internationale Anmeldenummer: PCT/EP2013/060247
(87) Internationale Veröffentlichungsnummer: WO 2014/005755

(56) Entgegenhaltungen:
- DE-A1- 4 314 601
- DE-A1- 19 620 391
- US-A- 4 889 140
- US-A1- 2004 065 643
- US-A1- 2009 212 033
- US-B1- 6 365 870

## Beschreibung

Die vorliegende Erfindung betrifft eine Vorrichtung zur Bearbeitung großflächiger Substrate mittels Laserstrahlung gemäß dem Oberbegriff des Anspruchs 1 (siehe, z.B., US 4 889 140).

Moderne Architektur bedient sich häufig großflächiger Fenster oder Glasfassaden, die einen ästhetisch ansprechenden Eindruck ergeben, ein angenehmes Raumklima erzeugen und auch im Winter ausreichenden Tageslichteinfall gewähren. Der Infrarotanteil des Sonnenlichts bewirkt jedoch besonders im Sommer eine starke Erwärmung der Wohnräume, wobei sich Fensterflächen mit großer Einstrahlfläche als nachteilig erweisen. Abhilfe schaffen können hier Verdunklungsvorrichtungen wie Jalousien, die jedoch kein Tageslicht durchlassen, oder die Installation einer Klimaanlage. Eine starke Erwärmung der Räume führt allerdings zu einem erhöhten Energieverbrauch der Klimaanlage und damit verbunden auch zu einem erhöhten Ausstoß von Treibhausgasen.

Eine effektive Möglichkeit Infrarotstrahlung bereits vor Eintritt in den Wohnraum abzuschirmen und gleichzeitig Tageslicht hindurchzulassen sind sogenannte Low-E-Beschichtungen. Low-E-Beschichtungen sind Wärmestrahlung reflektierende Beschichtungen, die einen erheblichen Teil der Infrarotstrahlung reflektieren, was im Sommer zu einer verringerten Erwärmung der Wohnräume führt. Des Weiteren kann der Verlust von Wärmestrahlung aus dem Innenraum verringert werden, wenn die Beschichtung auf der nach innen gewandten Seite der Scheibe aufgebracht ist. So trägt die Beschichtung auch zur Isolation des Wohnraums bei.

Low-E-Beschichtungen enthalten üblicherweise eine Diffusionssperre, einen metall- oder metalloxidhaltigen Multilayer und eine Sperrschicht. Die Diffusionssperre wird direkt auf die Glasoberfläche aufgebracht und verhindert eine Verfärbung durch Diffusion von Metallatomen ins Glas. Häufig werden Doppelsilberschichten oder Dreifachsilberschichten als Multilayer eingesetzt. Die verschiedensten Low-E-Beschichtungen sind beispielsweise bekannt aus DE 10 2009 006 062 A1, WO 2007/101964 A1, EP 0 912 455 B1, DE 199 27 683 C1, EP 1 218 307 B1 und EP 1 917 222 B1.

Die Abscheidung von Low-E-Beschichtungen erfolgt bevorzugt über das an sich bekannte Verfahren der magnetfeldunterstützten Kathodenzerstäubung. Durch magnetfeldunterstützte Kathodenzerstäubung abgeschiedene Schichten weisen eine amorphe Struktur auf und bewirken eine Trübung von durchsichtigen Substraten wie Glas oder transparenten Polymeren. Eine Temperaturbehandlung der amorphen Schichten bewirkt eine Kristallstrukturänderung hin zu einer kristallinen Schicht mit verbesserter Transmission. Der Temperatureintrag in die Beschichtung kann über eine Flammenbehandlung, einen Plasmabrenner, Infrarotstrahlung oder eine Laserbehandlung erfolgen.

WO 2008/096089 A2 offenbart ein Verfahren zur Abscheidung und Temperaturbehandlung dünner Schichten. Die Erwärmung einer auf einem Substrat aufgetragenen Schicht führt unweigerlich auch zur Erwärmung des Substrats selbst. Die Wärme wird aus der Schicht ins dazu in Kontakt stehende kältere Substrat abgeleitet. Somit entsteht ein Temperaturgradient entlang des Substrats, der thermische Spannungen hervorruft, die zum Bruch des Substrats führen können. Derartige Beschädigungen können vermieden werden indem die Schicht auf eine Temperatur von maximal 300 °C erwärmt wird, während gleichzeitig die Temperatur auf der gegenüberliegenden Seite des Glases auf unter 150 °C gehalten wird. Die Temperaturbehandlung erfolgt je nach Beschaffenheit der Schicht mittels verschiedenster Methoden, beispielsweise wird zum Tempern eines silberhaltigen Multilayers ein Laseraufbau eingesetzt. Handelsübliche Laser können jedoch nur einen kleinen Bereich bis zu einigen Hundert Millimetern abdecken. Aus diesem Grund wird ein Aufbau verwendet, der es ermöglicht den Laser senkrecht zur Laufrichtung des Transportbands mit Substrat zu bewegen und so die komplette Oberfläche abzudecken. Die Geschwindigkeit eines einzelnen Lasers ist jedoch besonders bei großen Substraten so gering, dass die Laserbehandlung nicht in-line mit der Beschichtung des Substrats erfolgen kann.

Eine weitere Möglichkeit zur Bearbeitung großflächiger Substrate wäre eine einzelne Laseroptik, die den gesamten Bereich des Substrats abdeckt ohne dabei ihre Position zu verändern. Eine einzelne optische Anordnung dieser Ausmaße benötigt jedoch eine aufwändige und teure Konstruktion aus mehreren optischen Komponenten, die einzeln justiert werden müssen.

Alternativ könnten mehrere Lasermodule nebeneinander montiert werden, wobei jedes Lasermodul einen Teilbereich der Substratoberfläche abdeckt. Mehrere nebeneinander montierte Lasereinheiten erfordern jedoch eine exakte Justierung, damit eine passgenaue Abdeckung der gesamten Substratbreite erfolgt.

Aus anderen Bereichen der Technik sind bereits Laserverfahren zur Bearbeitung großflächiger Substrate bekannt. US 2007/0211323 A1 beschreibt beispielsweise eine Laservorrichtung zur Herstellung von OLEDs (*organic light emitting displays),* wobei mehrere Laser beweglich auf einer Brücke angebracht sind und die Brücke auf zwei Führungsschienen in Richtung x und Richtung -x verfahrbar ist. DE 196 20 391 A1 1 offenbart ebenfalls eine Brückenstruktur mit mehreren Bearbeitungsköpfen. Auch hier ist eine Bewegung der Brücke in Richtung x und -x notwendig. Ein derartiges Vor- und Zurückfahren der Brücke in x- und -x-Richtung ist nicht mit einer zeitlich effizienten Laserbearbeitung von Substraten auf einem Transportband vereinbar, da auf diese Weise nur geringe absolute Transportgeschwindigkeiten erreicht werden. In US 4,889,140 und US 2009/0212033 A1 sind Laservorrichtungen mit mehreren Brücken offenbart, die ein Transportband überspannen. Dabei erfolgt jedoch nur eine punktuelle Bearbeitung des Substrats, eine großflächige Bearbeitung ist weder vorgesehen noch möglich.
Keine dieser Vorrichtungen ist zum flächendeckenden Tempern von Low-E-Beschichtungen großflächiger Glassubstrate in-line mit der Abscheidung dieser Low-E-Beschichtung geeignet.

Aufgabe der vorliegenden Erfindung ist es eine Vorrichtung zur Verfügung zu stellen, die ein Tempern von metallhaltigen oder metalloxidhaltigen Beschichtungen auf großflächigen Glassubstraten in-line mit einem Verfahren zur Abscheidung der Beschichtung ermöglicht, wobei gleichzeitig eine einfache Justierung der Lasermodule gewährleistet ist und die Laservorrichtung möglichst kostengünstig herstellbar sein soll.

Die Aufgabe der vorliegenden Erfindung wird erfindungsgemäß durch eine Laservorrichtung zur Laserbearbeitung großflächiger Glassubstrate, ein Verfahren zur Laserbearbeitung großflächiger Glassubstrate und die Verwendung der Laservorrichtung zur Bearbeitung von metallbeschichteten oder metalloxidbeschichteten Glassubstraten nach den Ansprüchen 1 und 12 und 15 gelöst. Bevorzugte Ausführungen der Erfindung gehen aus den Unteransprüchen hervor.

Die Laservorrichtung zur Bearbeitung großflächiger planarer Glassubstrate umfasst zumindest mehrere Laserquellen, mehrere optische Anordnungen und mindestens zwei Brücken, die ein Transportband überspannen. Auf dem Transportband befindet sich das zu bearbeitende Glassubstrat. Bevorzugt entspricht die Größe des Glassubstrats dem für Float-Glas üblichen Standardformat von 3 m x 6 m, wobei die kürzere Kante des Substrats parallel zu den Brücken auf dem Transportband aufliegt. Vorzugsweise befindet sich die Laservorrichtung am Ende einer Produktionslinie zur Abscheidung einer metallhaltigen oder metalloxidhaltigen Beschichtung auf den Glassubstraten, wobei die Laserbearbeitung in-line mit der Beschichtung erfolgen kann. Die optischen Anordnungen sind alternierend auf den Brücken angebracht. Jede optische Anordnung erzeugt eine Laserlinie und die Laserlinien aller optischen Anordnungen decken zusammen die gesamte Breite des Glassubstrats ab. Als gesamte Breite des Glassubstrats wird dabei die maximale Ausdehnung des Substrats senkrecht zur Transportrichtung des Transportbands bezeichnet.

In einer bevorzugten Ausführung der erfindungsgemäßen Laservorrichtung sind zwei Brücken quer über dem Transportband angebracht. Die optischen Anordnungen sind alternierend auf beiden Brücken aufgebracht, so dass eine erste optische Anordnung auf der ersten Brücke und die in Querrichtung dazu nächstliegende optische Anordnung auf der zweiten Brücke montiert ist. Die nachfolgende optische Anordnung ist wieder auf der ersten Brücke angebracht. Diese alternierende Anordnung bedingt, dass sich auf der zweiten Brücke eine optische Anordnung mehr befindet als auf der ersten Brücke. Allgemein beträgt die Anzahl der optischen Anordnungen auf der ersten Brücke n und auf der zweiten Brücke n+1, wobei n eine natürliche Zahl größer 1 ist. Alternativ kann auch die Anzahl der optischen Anordnungen auf der zweiten Brücke n und auf der ersten Brücke n+1 betragen. Bevorzugt beträgt die Gesamtzahl der optischen Anordnungen 5 bis 15, besonders bevorzugt 10 bis 12.

Eine weitere Ausführungsform der erfindungsgemäßen Laservorrichtung beinhaltet zusätzlich zur ersten und zweiten Brücke eine dritte Brücke über dem Transportband. Die optischen Anordnungen sind alternierend auf allen drei Brücken angeordnet. Die erste optische Anordnung ist dabei auf der ersten Brücke, die in quer zur Transportrichtung nächstliegende optische Anordnung auf einer anderen Brücke und die darauffolgende optische Anordnung auf der noch unbesetzten Brücke montiert. Die Reihenfolge der drei Brücken ist dabei beliebig. Bevorzugt beträgt die Gesamtzahl der optischen Anordnungen 5 bis 15, besonders bevorzugt 10 bis 12. Eine Laservorrichtung mit drei Brücken wird bevorzugt eingesetzt, wenn der Platzanspruch der optischen Anordnungen so groß ist, dass diese nicht mehr auf zwei Brücken platziert werden können.

Die Anzahl der Laserquellen entspricht bevorzugt mindestens der Anzahl der Brücken. Die Laserquellen können jeweils auf den Brücken direkt neben den optischen Anordnungen angebracht werden oder neben den Brücken. Der von der Laserquelle emittierte Laserstrahl wird über einen Spiegel oder einen Lichtleiter zur optischen Anordnung gelenkt. Alternativ kann auch eine einzelne Laserquelle für alle optischen Anordnungen auf allen Brücken verwendet werden.

Werden die Laserquellen direkt neben den optischen Anordnungen auf der Brücke angebracht so ist eine Laserquelle pro optischer Anordnung nötig. Bevorzugt sind die Laser in diesem Fall beweglich auf den Brücken montiert, so dass die Position der Laser bei einer Verschiebung der optischen Anordnungen ebenfalls variiert werden kann. Somit wird die Justierung der Laser und der optischen Anordnung quer zur Transportrichtung des Transportbandes ermöglicht. Alternativ können die Laser auch feststehend angebracht werden, wenn der Justierungsbereich der optischen Anordnungen kleiner ist als der Abstand zwischen optischer Anordnung und Laserquelle. Bei geringer Entfernung zwischen Laserquelle und optischer Anordnung und ungehindertem Strahlverlauf kann der Laserstrahl direkt über einen Spiegel zur optischen Anordnung geleitet werden. Dies ist besonders vorteilhaft wenn die Laserquellen direkt benachbart zu den optischen Anordnungen auf der Brücke aufgebracht sind.

In einer alternativen Ausführungsform wird nur eine Laserquelle pro Brücke benötigt, die neben der Brücke oder am Rand der Brücke angebracht ist. Der Laserstrahl wird dabei über einen Lichtleiter, bevorzugt ein Glasfaserkabel, von der Laserquelle zu den optischen Anordnungen gelenkt.

Die optischen Anordnungen umfassen mindestens einen Laserscanner, eine Linse und eine Blende. Als Laserscanner kann ein Polygonscanner oder ein Galvanoscanner eingesetzt werden.

Bevorzugt wird ein Polygonscanner als Laserscanner eingesetzt. Der Laserstrahl wird zunächst durch eine Linse auf die Fläche des Polygons fokussiert. Dabei ist nur eine Linse mit einem kleinen Durchmesser nötig, was im Hinblick auf die Kosten der Laservorrichtung vorteilhaft ist. Der Laserstrahl wird durch die Linse auf eine Breite von ungefähr 50 µm fokussiert. Der Durchmesser der Linse beträgt beispielsweise 5 cm. Das zentrale Bauteil des Polygonscanners ist ein vielflächiges bewegliches Spiegelprisma, das mit ca. 10.000 Umdrehungen pro Minute rotiert und auf diese Weise eine Linie des Substrats kontinuierlich abtastet. Die von den verwendeten Polygonscannern erreichten Scan-Geschwindigkeiten liegen bei mehr als 10 Metern pro Sekunde, bevorzugt bei 25 Metern pro Sekunde. Aufgrund der hohen Rotationsgeschwindigkeit des Spiegels bildet sich eine kontinuierliche homogene Laserlinie. Die Länge der Laserlinie wird durch die Anzahl und die Länge der Facetten des Polygonspiegels und dessen Abstand zur Substratoberfläche bestimmt. Bevorzugt werden Optikanordnungen verwendet, die eine 100 mm bis 1000 mm, bevorzugt 200 mm bis 400 mm, breite Laserlinie erzeugen. Diese Laserlinie wird durch eine Blende geleitet, die die Endpunkte der Laserlinie beschneidet und trifft danach auf die Oberfläche des Substrats. Die Oberfläche des Substrats befindet sich dabei im Fokuspunkt der Laserlinie. Der Fokus der Laserlinie ist somit über den Abstand der optischen Anordnung zur Substratoberfläche einstellbar.

Alternativ kann ein Galvanometerscanner als Laserscanner eingesetzt werden. Die Funktionsweise des Galvanometerscanners ähnelt der des Polygonscanners, wobei der Galvanometerscanner jedoch nur über einen Spiegel anstelle des Spiegelprismas verfügt. Somit ist die maximale Scan-Geschwindigkeit des Galvanometerscanners mit 5 m pro Sekunde wesentlich kleiner als die Geschwindigkeit des Polygonscanners. Der von der Laserquelle emittierte Laserstrahl trifft direkt auf den Spiegel des Galvanometerscanners und wird von dort auf eine Linse gelenkt, die den Laserstrahl auf eine Breite von ungefähr 50 µm fokussiert. Ummittelbar hinter der Linse befindet sich eine Blende, die die Endpunkte der Laserlinie beschneidet. Die Breite der erzeugten Laserlinie ist bei Wahl eines Galvanometerscanners mit einer Scangeschwindigkeit von 5 Metern pro Sekunde begrenzt auf maximal 300 mm.

Der Abstand der optischen Anordnungen zur Oberfläche des Substrats beträgt bevorzugt 10 cm bis 100 cm, wobei die Fokussierung der Laserlinie bei Verwendung eines Polygonscanners über die Variation ebendieses Abstandes erfolgt. Die optischen Anordnungen sind entlang der Brücken quer zur Transportrichtung des Transportbandes beweglich, wodurch eine einfache Justierung der optischen Anordnungen gewährleistet wird. Die alternierende Anordnung der optischen Anordnungen auf den Brücken ermöglicht eine voneinander unabhängige Justierung der optischen Anordnungen, da hinreichend Platz zur Verschiebung der optischen Anordnungen besteht und sich diese nicht räumlich behindern. Die optischen Anordnungen sind entlang der Brücken um 1 cm bis 20 cm, bevorzugt 5 cm bis 15 cm, beweglich.

Die Laserlinien der einzelnen optischen Anordnungen addieren sich zu einem Beleuchtungsbereich der die gesamte Breite des Glassubstrats abdeckt. Die Laserlinien benachbarter optischer Anordnungen decken dabei einen gemeinsamen Substratbereich von 0,1 cm bis 0,3 cm ab, der von beiden Laserlinien beleuchtet wird. Durch diese Überschneidung der bearbeiteten Bereiche der einzelnen Laserlinien wird gewährleistet, dass die komplette Fläche des Glassubstrats abgedeckt ist und keine Lücken am Übergang zwischen zwei Bearbeitungsbereichen entstehen.

Bevorzugt haben die Brücken einen Abstand von 20 cm bis 90 cm, bevorzugt 40 cm bis 60 cm zueinander.

Als Laserquellen werden bevorzugt kontinuierliche oder gepulste Festkörperlaser eingesetzt. Besonders bevorzugt wird ein Neodym-dotierter Yttrium-Aluminium-Granat-Laser (Nd:YAG-Laser) verwendet. Alternativ können auch Ytterbium (Yb:YAG-Laser) oder Erbium (Er:YAG-Laser) als Dotierungsmaterialien verwendet werden oder Titan:Saphir-Laser oder Neodym-dotierte Yttrium-Vanadat-Laser (Nd:YVO₄-Laser) eingesetzt werden. Der Nd:YAG-Laser emittiert infrarote Strahlung einer Wellenlänge von 1064 nm. Durch Frequenzverdopplung bzw. Frequenzverdreifachung kann jedoch auch Strahlung der Wellenlängen 532 nm und 355 nm erzeugt werden.

Die Laserbearbeitung erfolgt mit einer Wellenlänge von 300 nm bis 1300 nm. Die eingesetzte Wellenlänge hängt dabei von der Art der Beschichtung ab. Die Wellenlänge der Laserstrahlung muss dabei in einem Bereich liegen, in dem die Beschichtung diese absorbiert und somit durch den Energieeintrag erwärmt werden kann. Der bevorzugt verwendete Nd:YAG-Laser kann Laserstrahlung der Wellenlängen 355 nm, 532 nm und 1064 nm bereitstellen. Für die Bearbeitung von Silberbeschichtungen wird bevorzugt eine Wellenlänge von 1064 nm eingesetzt.

Die zur Laserbearbeitung benötigte Gesamtleistung hängt stark vom Design der optischen Anordnungen, dem Aufbau der Anlage und der Strahlführung des Laserstrahls ab. Typische Leistungswerte liegen zwischen 1 kW und 16 kW.

Die Laserleistung ist ebenfalls an die Schichtdicke, den Schichtaufbau und die Zusammensetzung der Beschichtung anzupassen.

Die Erfindung umfasst des Weiteren ein Verfahren zur kontinuierlichen Laserbearbeitung großflächiger planarer Glassubstrate mit der erfindungsgemäßen Laservorrichtung. In einem ersten Schritt werden die optischen Anordnungen entlang der Brücken so justiert, dass diese zusammen die gesamte Breite des Substrats abdecken. Bevorzugt überschneiden sich die Bereiche der einzelnen optischen Anordnungen dabei um 500 µm bis 1 cm, bevorzugt 0,1 cm bis 0,3 cm. In einem zweiten Schritt des erfindungsgemäßen Verfahrens werden die Geschwindigkeiten des Transportbandes und der Laserscanner synchronisiert. Diese Synchronisierung gewährleistet eine gleichmäßige Bearbeitung der Oberfläche, wobei die Produktqualität stichprobenartig durch Messung des elektrischen Widerstands und der Transmission überprüft wird. Der Wert der Transmission sollte durch Laserbearbeitung in allen Bereichen gleichmäßig ansteigen, während der elektrische Widerstand absinkt. Alternativ kann die Überprüfung der Beschichtung auch manuell erfolgen, da die Laserspuren optisch gut erkennbar sind.

Daraufhin werden die Glassubstrate auf das Transportband aufgelegt. Bevorzugt erfolgt die Laserbearbeitung der Glassubstrate direkt im Anschluss an die Abscheidung einer Beschichtung, wobei beide Prozesse in-line verlaufen. Die Geschwindigkeit der Laserbearbeitung ist nach dem erfindungsgemäßen Verfahren mindestens gleich der Geschwindigkeit des Beschichtungsprozesses, so dass eine Verlangsamung des Transportbandes wie bei den nach dem Stand der Technik üblichen Verfahren hier nicht notwendig ist. Das Transportband hat bevorzugt eine Geschwindigkeit von 5 m bis 15 m pro Minute, besonders bevorzugt 9 m bis 11 m pro Minute. Im letzten Schritt des Prozesses durchlaufen die Substrate die Brücken und werden vollkontinuierlich mittels der auf den Brücken angebrachten Laseranordnungen bearbeitet. Die Laserscanner müssen dabei am Übergang zwischen Glassubstraten und auch bei einer zwischen zwei Glassubstraten auftretenden größeren Lücke nicht abgeschaltet werden.

Die Erfindung umfasst ferner die Verwendung der erfindungsgemäßen Laservorrichtung zur Bearbeitung von metallbeschichteten oder metalloxidbeschichteten Glassubstraten, besonders bevorzugt großflächigen Glassubstraten mit einer Breite von 1 m bis 6 m, bevorzugt mit einer Breite von mindestens 3 m. Die erfindungsgemäße Laservorrichtung und das erfindungsgemäße Verfahren eignen sich besonders zur Bearbeitung von Glassubstraten im üblichen Floatglas-Standardformat von 3 Metern Breite und 6 Metern Länge.

Die verwendeten Glassubstrate enthalten Kalk-Natron-Glas, Quarzglas, Borsilikatglas und/oder transparente Kunststoffe wie Polymethylmethacrylat. Bevorzugt wird Floatglas eingesetzt.

Die Beschichtung des Glassubstrats umfasst bevorzugt Metallschichten oder Oxide wie TCO-Schichten *(transparent conductive oxide),* beispielsweise Silberschichten oder ITO-Schichten (*indium tin oxide*). Besonders bevorzugt wird eine Silberschicht mit einer Dicke von 6 nm bis 15 nm umgeben von zwei Sperrschichten mit einer Dicke von 0,5 nm bis 2 nm enthaltend Nickel-Chrom und/oder Titan eingesetzt. Zwischen einer Sperrschicht und der Glasoberfläche ist bevorzugt eine Diffusiossperre mit einer Dicke von 25 nm bis 35 nm enthaltend Si₃N₄, TiO₂, SnZnO und/oder ZnO aufgebracht. Auf die obere Sperrschicht ist der Umgebung zugewandt bevorzugt eine Diffusionssperre mit einer Dicke von 35 nm bis 45 nm enthaltend ZnO und/oder Si₃N₄ aufgetragen. Diese obere Diffusionssperre ist optional mit einer Schutzschicht mit einer Dicke von 1 nm bis 5 nm umfassend TiO₂ und/oder SnZnO₂ ausgestattet. Die Gesamtdicke aller Schichten beträgt bevorzugt 67,5 nm bis 102 nm.

Im Folgenden wird die Erfindung anhand einer Zeichnung näher erläutert. Die Zeichnung schränkt die Erfindung in keiner Weise ein.

Es zeigen:
Figur 1a eine erfindungsgemäße Laservorrichtung mit zwei Brücken über einem Transportband.
Figur 1b die erfindungsgemäße Laservorrichtung aus Figur 1a mit detaillierter Darstellung des Strahlengangs.
Figur 2 eine weitere Ausführungsform der erfindungsgemäßen Laservorrichtung, wobei der Laserstrahl über Lichtleiter zu den optischen Anordnungen gelenkt wird.
Figur 3 eine Draufsicht der erfindungsgemäßen Laservorrichtung aus Figur 1a.
Figur 4 eine alternative Ausführungsform der erfindungsgemäßen Laservorrichtung mit drei Brücken über einem Transportband.
Figur 5 eine Draufsicht der erfindungsgemäßen Laservorrichtung aus Figur 4.
Figur 6 die Bearbeitungsbereiche der erfindungsgemäßen Laservorrichtung aus Figur 1a auf einem Glassubstrat.
Figur 7 einen zur Erzeugung der Laserlinie verwendeten Polygonscanner.
Figur 8 einen zur Erzeugung der Laserlinie verwendeten Galvanometerscanner.
Figur 9 ein erfindungsgemäßes Verfahren zur Laserbearbeitung großflächiger Substrate.

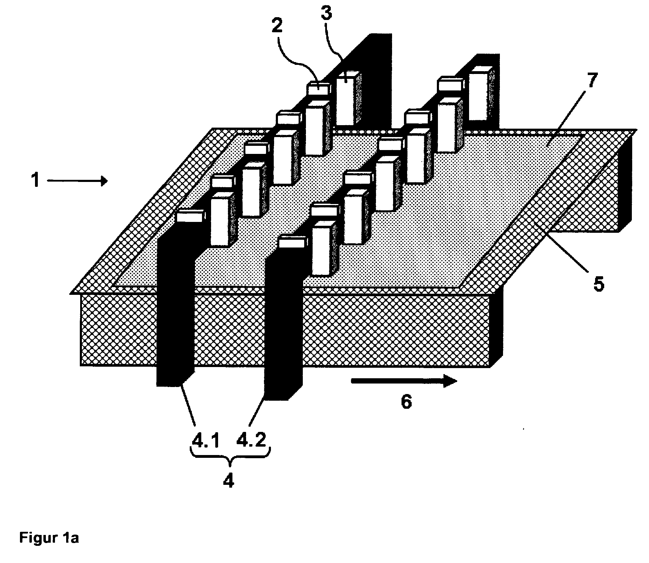

Figur 1a zeigt die erfindungsgemäße Laservorrichtung (1) mit zwei Brücken (4) über einem Transportband (5). Die Brücken (4) überspannen das Transportband (5) quer zur Transportrichtung (6). Auf dem Transportband (5) liegt ein Glassubstrat (7) auf, das unter den Brücken (4) hindurch transportiert wird. Auf der ersten Brücke (4.1) und der zweiten Brücke (4.2) sind optische Anordnungen (3) angebracht. Neben den optischen Anordnungen (3) befindet sich auf den Brücken (4) jeweils eine Laserquelle (2) pro optischer Anordnung (3). Auf der ersten Brücke (4.1) sind fünf optische Anordnungen (3) mit fünf Laserquellen (2) angebracht, während auf der zweiten Brücke (4.2) sechs optische Anordnungen (3) und sechs Laserquellen (2) montiert sind. Die optischen Anordnungen (3) sind alternierend auf beiden Brücken (4) angebracht. Diese alternierende Anordnung der optischen Anordnungen (3) auf beiden Brücken (4) gewährleistet genügend Platz zur Justierung der optischen Anordnungen (3) entlang der Brücken (4), da der Abstand benachbarter optischer Anordnungen (3) hinreichend groß ist. Zur Bearbeitung von Glassubstraten (7) mit einer Breite von 3 Metern wird bevorzugt eine derartige Laservorrichtung (1) mit insgesamt 11 optischen Anordnungen (3) eingesetzt, wobei jede optische Anordnung (3) eine Laserlinie mit 300 mm Breite erzeugt und somit das Glassubstrat (7) in seiner gesamten Breite abgedeckt wird.

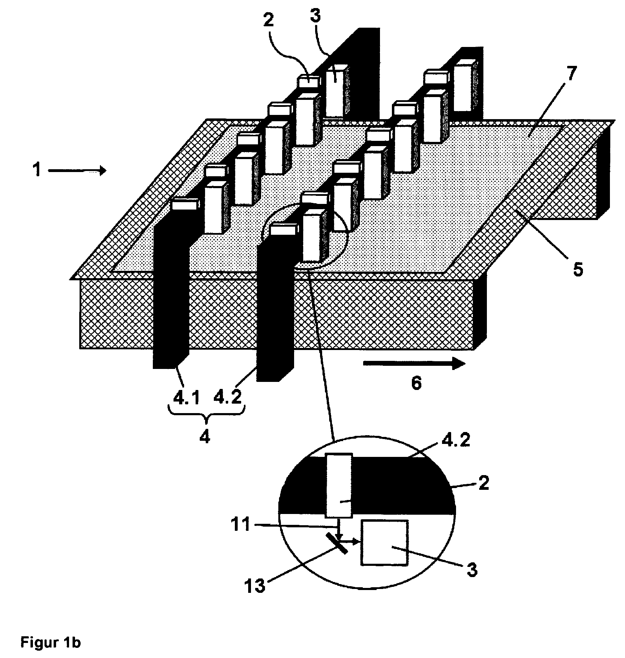

Figur 1b zeigt die erfindungsgemäße Laservorrichtung (1) aus Figur 1a, wobei der Verlauf des Laserstrahls (11) im Detail dargestellt ist. Der von einer Laserquelle (2) erzeugte Laserstrahl (11) wird über einen Spiegel (13) zur benachbarten optischen Anordnung (3) gelenkt und tritt über eine seitliche Gehäuseöffnung in diese ein. Die Laserquelle (2), der zugehörige Spiegel (13) und die zugehörige optische Anordnung (3) sind beweglich auf den Brücken (4) montiert, so dass die Anordnung leicht entlang der Brücken (4) verschoben werden kann. Der Abstand der optischen Anordnung (3) zur Oberfläche des Glassubstrats (7) ist ebenfalls variabel, wobei die Höhe der Laserquelle (2) und des Spiegels (13) im Allgemeinen nicht verändert werden muss. Eine Höhenanpassung der optischen Anordnungen (3) ist je nach deren Ausführungsform notwendig um eine Fokussierung auf der Oberfläche des Glassubstrats (7) zu gewährleisten. Da es sich dabei jedoch um vergleichsweise kleine Höhenanpassungen handelt müssen die Höhe des Spiegels (13) und der Laserquelle (2) nicht verändert werden, sondern der Verlauf des Laserstrahls (11) kann alleinig durch Drehung des Spiegels neu justiert werden.

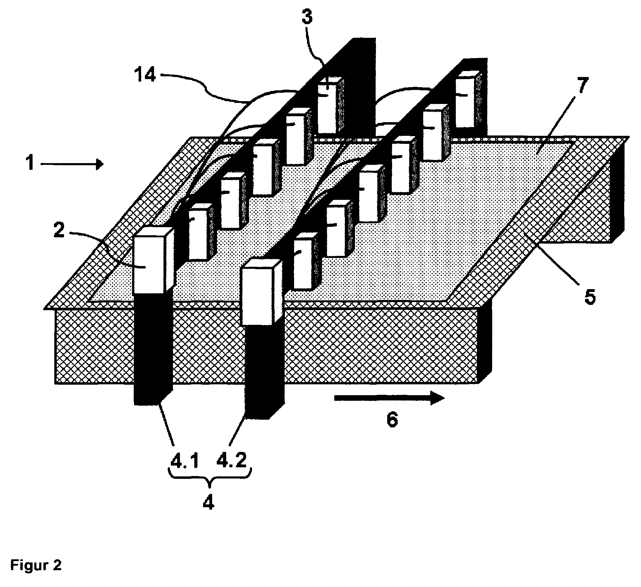

Figur 2 zeigt eine weitere Ausführungsform der erfindungsgemäßen Laservorrichtung (1), wobei der Laserstrahl (11) über Lichtleiter (14) zu den optischen Anordnungen (3) gelenkt wird. Der generelle Aufbau entspricht dabei dem im Figur 1a gezeigten. Abweichend davon ist nur eine Laserquelle (2) pro Brücke (4) erforderlich, die am Rand der Brücke (4) aufgebaut ist. Von den Laserquellen (2) wird der Laserstrahl durch je einen Lichtleiter (14) zu jeweils einer optischen Anordnung (3) geführt. Diese Ausführungsform bietet den Vorteil, dass auf Spiegel zur Lenkung des Laserstrahls verzichtet wird und somit die Neujustierung dieser Spiegel bei bereits kleinen Positionsänderungen der optischen Anordnung (3) entfällt. Der hier verwendete Lichtleiter (14) weist hingegen eine eingeschränkte Beweglichkeit auf, so dass kleinere Änderungen in der Position der optischen Anordnung (3) im Toleranzbereich liegen und keinerlei Neujustierung bedürfen.

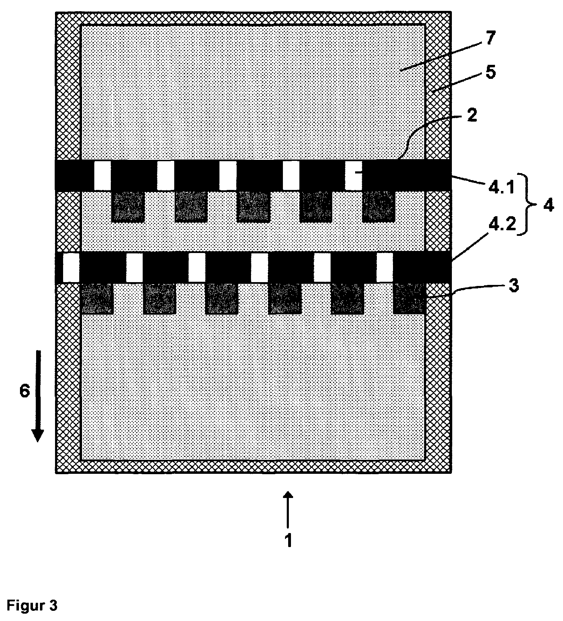

Figur 3 zeigt eine Draufsicht der erfindungsgemäßen Laservorrichtung (1) aus Figur 1a. Die optischen Anordnungen (3) sind in alternierender Reihenfolge auf der ersten Brücke (4.1) und der zweiten Brücke (4.2) angeordnet. Dabei decken die Bearbeitungsbereiche der optischen Anordnungen (3) das Glassubstrat (7) in seiner kompletten Breite entlang der Brücken (4) ab.

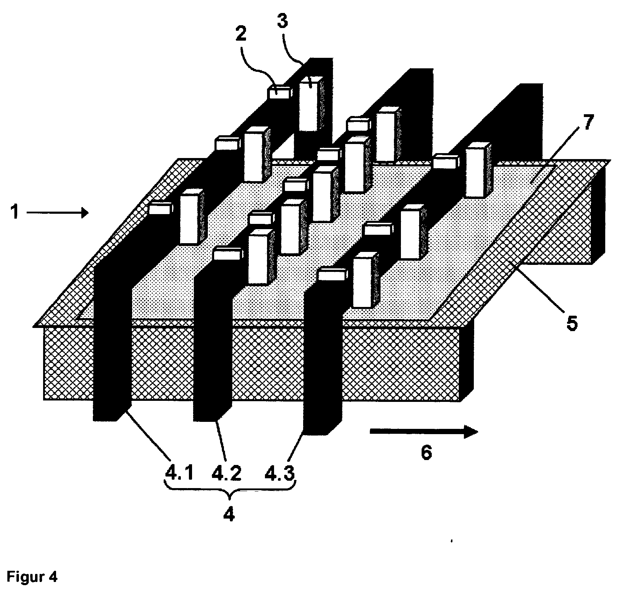

Figur 4 zeigt eine alternative Ausführungsform der erfindungsgemäßen Laservorrichtung (1) mit drei Brücken (4) über einem Transportband (5) mit Glassubstrat (7). Auf der ersten Brücke (4.1) sind dabei drei optische Anordnungen (3), auf der zweiten Brücke (4.2) fünf optische Anordnungen (3) und auf der dritten Brücke (4.3) drei optische Anordnungen (3) alternierend angebracht. Die Verteilung der optischen Anordnungen (3) auf den Brücken (4) ist variabel, wobei einzig zu beachten ist, dass Bearbeitungsbereiche der einzelnen optischen Anordnungen (3) zusammen die gesamte Breite des Glassubstrats (7) abdecken. Neben den optischen Anordnungen (3) ist jeweils eine Laserquelle (2) auf den Brücken (4) montiert. Alternativ ist jedoch auch eine Reduzierung der Laserquellen unter Einsatz von Lichtleiterkabeln denkbar, wie in Figur 2 gezeigt.

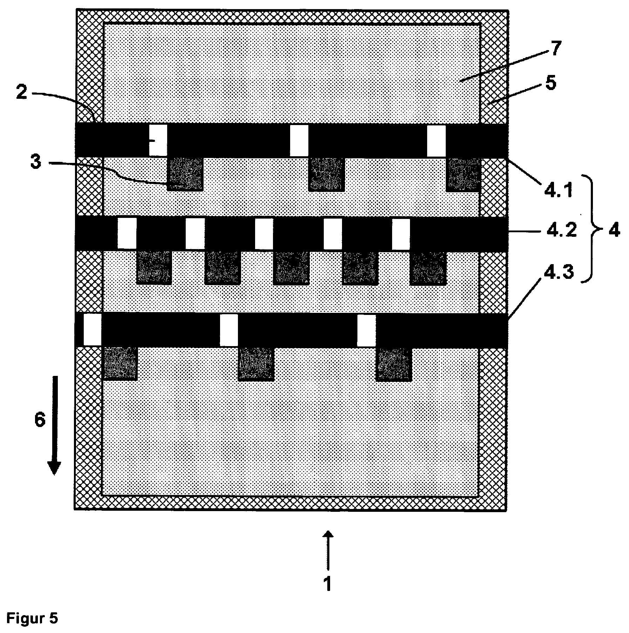

Figur 5 zeigt eine Draufsicht der erfindungsgemäßen Laservorrichtung (1) aus Figur 4, wobei die alternierende Anordnung der optischen Anordnungen (3) auf den drei Brücken (4) erkennbar ist. Auf der ersten Brücke (4.1) und der dritten Brücke (4.3) sind jeweils drei optische Anordnungen (3) angebracht, während auf der zweiten Brücke (4.2) fünf optische Anordnungen (3) montiert sind. Jede optische Anordnung (3) deckt einen Teilbereich des Glassubstrats (7) ab, wobei die einzelnen Bereiche der optischen Anordnungen (3) gemeinsam die Gesamtbreite des Glassubstrats (7) im Bereich der Brücken (4) abdecken.

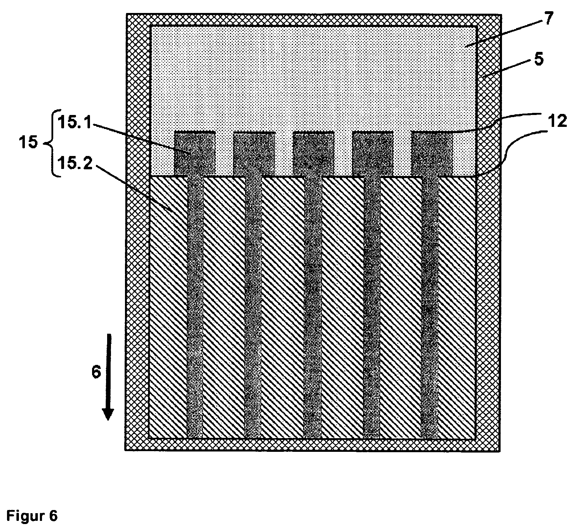

Figur 6 zeigt die Bearbeitungsbereiche (15) der erfindungsgemäßen Laservorrichtung (1) aus Figur 1 a auf dem Glassubstrat (7). Die auf dem Glassubstrat (7) erzeugten Laserlinien (12) werden durch die Bewegung des Transportbandes (5) der Länge nach über das Glassubstrat (7) geführt. Dadurch entstehen auf dem Glassubstrat (7) mehrere Bearbeitungsbereiche (15), wobei die Bearbeitungsbereiche der ersten Brücke (15.1) zwischen den Bearbeitungsbereichen der zweiten Brücke (15.2) liegen und mit diesen überlappen. Durch diese Überlappung gemäß der Erfindung wird sichergestellt, dass keine unbearbeiteten Bereiche entstehen. Das Glassubstrat (7) wird über das Transportband (5) in Transportrichtung (6) befördert, so dass die Oberfläche des Glassubstrats (7) vollständig bearbeitet wird.

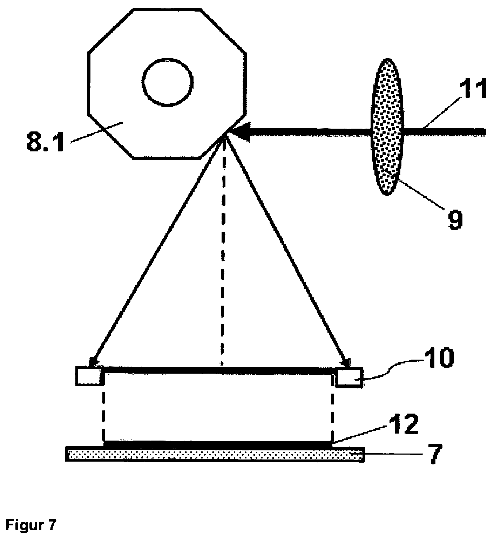

Figur 7 zeigt einen zur Erzeugung einer Laserlinie (12) verwendeten Polygonscanner (8.1). Der Laserstrahl (11) wird nach Eintritt in die optische Anordnung (3) durch eine Linse (9) auf eine Fläche des Polygonscanners (8.1) fokussiert. Der rotierende Polygonscanner (8.1) spiegelt den Laserstrahl (11) auf die Oberfläche des Glassubstrats (7). Durch die schnelle Rotationsbewegung des Polygonscanners (11) entsteht dabei eine Laserlinie (12). Die Enden der Laserlinie (12) werden durch eine Blende (10) beschnitten. Die Fokussierung der Laserlinie (12) auf der Oberfläche des Glassubstrats (7) erfolgt durch Höhenanpassung des Polygonscanners (8.1) zur Substratoberfläche.

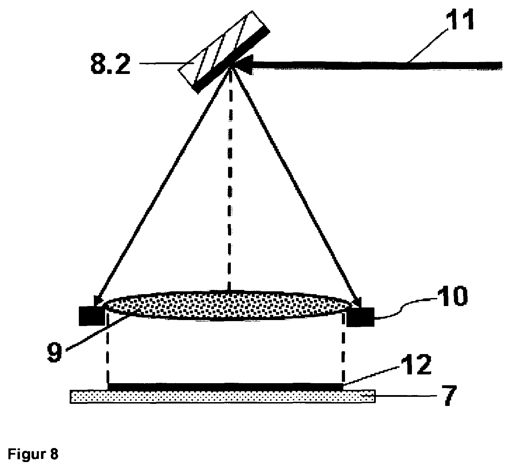

Figur 8 zeigt einen zur Erzeugung einer Laserlinie verwendeten Galvanometerscanner (8.2), der alternativ zu einem Polygonscanner (8.1) als Laserscanner (8) in den optischen Anordnungen (3) enthalten sein kann. Der Laserstrahl (11) tritt in das Gehäuse der Optik (3) ein und wird von einem Galvanometerscanner (8.2) auf eine Linse (9) gelenkt. Der Galvanometerscanner (8.2) erzeugt durch Rotation eine Laserlinie (12), die durch die Linse auf die Oberfläche des Glassubstrats (7) fokussiert wird. Die Linse (9) ist in einer Blende (10) eingelassen, die Enden der Laserlinie (12) beschneidet. Die Länge der Laserlinie ist dabei durch die Größe der Linse begrenzt.

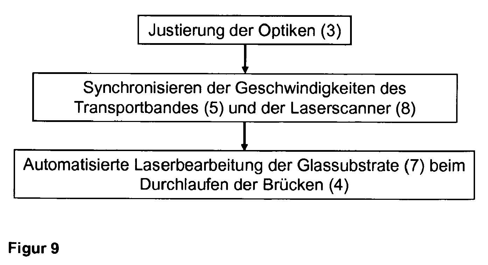

Figur 9 zeigt ein erfindungsgemäßes Verfahren zur Laserbearbeitung großflächiger Glassubstrate (7). In einem ersten Schritt erfolgt die Justierung der optischen Anordnungen (3) auf die Breite des Glassubstrats (7). Die optischen Anordnungen (3) werden so ausgerichtet, dass das Glassubstrat (7) in seiner vollen Breite bearbeitet werden kann und die Bearbeitungsbereiche (15) der einzelnen optischen Anordnungen (3) teilweise überlappen. Nachfolgend werden die Geschwindigkeiten des Transportbandes (5) und der Laserscanner (8) synchronisiert. Das erfindungsgemäße Verfahren ermöglicht eine schnellere Bearbeitung der Glassubstrate (7) als die nach dem Stand der Technik bekannten Verfahren, da die optischen Anordnungen (3) stationär montiert sind und während des Verfahrens nicht bewegt werden müssen. Somit kann die Laserbearbeitung nach dem erfindungsgemäßen Verfahren bevorzugt direkt im Anschluss an die Beschichtung der Glassubstrate (7) mittels Sputtering erfolgen, ohne dass die Geschwindigkeit des Transportbandes (5) gedrosselt werden muss. Im nächsten Schritt werden die Glassubstrate (7) auf das Transportband (5) aufgelegt. Bei einer in-line-Anordnung einer Beschichtungsanlage und der erfindungsgemäßen Laservorrichtung (1) werden die Glassubstrate (7) bereits vor der Beschichtungsanlage auf das Transportband (5) aufgelegt. Danach durchlaufen die Glassubstrate (7) auf dem Transportband (5) die Brücken (4) und werden von den optischen Anordnungen (3) automatisiert bearbeitet.

Im Folgenden wird die Erfindung anhand eines Beispiels des erfindungsgemäßen Verfahrens und eines Vergleichsbeispiels näher erläutert.

In zwei Versuchsreihen wurden die maximal erreichbaren Geschwindigkeiten des Transportbandes (5) und die Kosten aller optischen Komponenten bei Laserbearbeitung eines großflächigen Glassubstrats (7) unter Verwendung der erfindungsgemäßen Laservorrichtung (1) und unter Verwendung einer nach dem Stand der Technik bekannten Laservorrichtung verglichen. Die Abmaße der verwendeten Glassubstrate (7) betrugen in allen Versuchen 3 Meter in der Breite und 6 Meter in der Länge. Die Glassubstrate (7) wurden mit der langen Seitenkante parallel zur Transportrichtung (6) des Transportbandes (5) auf dieses aufgelegt. Die erfindungsgemäße Laservorrichtung (1) und die Laservorrichtung nach dem Stand der Technik wurden jeweils in-line mit einer Beschichtungsanlage eingesetzt, wobei die Glassubstrate (7) direkt im Anschluss an die Abscheidung der Beschichtung mittels der Laservorrichtungen bearbeitet werden. Als Beschichtungsanlage wurde eine Magnetron-Sputtering-Anlage verwendet, in der in dieser Reihenfolge eine 30 nm dicke Si₃N₄-Schicht, eine 10 nm dicke Silberschicht, eine 1 nm dicke Nickel-Chrom-Schicht, eine 40 nm dicke ZnO-Schicht und eine 4 nm dicke TiO₂-Schicht auf die Substratoberfläche aufgetragen wurden. Die Silberschicht verfügt direkt nach der Abscheidung über eine amorphe Struktur. Durch Tempern der Beschichtung erfolgt der Übergang von der amorphen in eine kristalline Struktur, wodurch die Transparenz der Beschichtung verbessert wird. Für derartige Temperaturbehandlungen haben sich Laserverfahren als besonders geeignet erwiesen. In allen Versuchsreihen wurden die Laservorrichtungen zum Tempern der Beschichtung direkt an die Beschichtungsanlage grenzend angeordnet, so dass eine direkte Weiterbehandlung der Glassubstrate erfolgte. Der Laserprozess ist üblicherweise der langsamste Schritt des Verfahrens. Eine Beschleunigung des Laserverfahrens geht somit mit einer Beschleunigung des kompletten Produktionsprozesses und der damit verbundenen Kostenersparnis einher. Andererseits sollen die Kosten für die Laseranordnung möglichst gering gehalten werden. Die bei der Bearbeitung der Glassubstrate mit der erfindungsgemäßen Laservorrichtung und einer Laservorrichtung nach dem Stand der Technik maximal möglichen Geschwindigkeiten des Transportbandes sowie die Anschaffungskosten der optischen Komponenten der Laservorrichtungen wurden anhand der Versuchsreihen verglichen.
a) Beispiel 1: Bearbeitung großflächiger Glassubstrate (7) mittels der erfindungsgemäßen Laservorrichtung (1)
   Über dem Transportband (5) wurden zwei Brücken (4) im Abstand von 50 cm angebracht, die das Transportband (5) parallel zur kurzen Seitenkante der darauf aufliegenden Glassubstrate (7) überspannen. Auf der ersten Brücke (4.1) wurden fünf optische Anordnungen (3) montiert, während auf der zweiten Brücke alternierend zu den optischen Anordnungen (3) der ersten Brücke (4.1) sechs weitere optische Anordnungen (3) angebracht wurden. Die optischen Anordnungen (3) wurden so ausgerichtet, dass die Blende (10), durch die die Laserlinie (12) austritt, in Richtung des Glassubstrates (7) zeigt. Am Rand jeder Brücke (4) wurde eine Laserquelle (2) positioniert, deren Laserstrahl (11) durch Lichtleiter (14) zu den optischen Anordnungen (3) geleitet wurde. Der Laserstrahl (11) trat durch eine seitliche Öffnung in die optische Anordnung (3) ein und wurde dort von einer Linse (9) auf einen Polygonscanner (8.1) gelenkt. Der Polygonscanner (8.1) rotierte mit 10.000 Umdrehungen pro Minute und erzeugte so eine kontinuierliche Laserlinie (12), die auf das Glassubstrat (7) reflektiert wurde. Der verwendete Polygonscanner (8.1) wies eine Scanngeschwindigkeit von 10 m pro Sekunde auf. Die Enden der Laserlinie (12) wurden beim Durchtritt der Laserlinie (12) durch die Blende (10) beschnitten. Die optischen Anordnungen (3) wurden so justiert, dass sich die Bearbeitungsbereiche (15) der in Querrichtung benachbarten optischen Anordnungen (3) auf dem Glassubstrat (7) um jeweils 0,2 cm überlappen. Als Laserquellen wurden Neodym-dotierte Yttrium-Aluminium-Granat-Laser (Nd:YAG-Laser) eingesetzt.
b) Vergleichsbeispiel 2: Bearbeitung großflächiger Glassubstrate (7) mit einer nach dem Stand der Technik bekannten Laservorrichtung

In Vergleichsbeispiel 2 erfolgte die Bearbeitung der großflächigen Glassubstrate (7) mit der unter dem Namen "Volcano Line Beam 750 Laser Optics" vertriebenen Laservorrichtung der Firma Innovavent. Dabei wurde ein Nd:YAG-Laser (Starlase 400G US) mit einer Wellenlänge von 532 nm eingesetzt.

Tabelle 1 zeigt die maximal möglichen Geschwindigkeiten des Transportbands (5) sowie die Kosten aller optischen Komponenten für die erfindungsgemäße Laservorrichtung (Beispiel 1) und die nach dem Stand der Technik bekannte Laservorrichtung (Vergleichsbeispiel 2).

**Tabelle 1**

| | Maximalgeschwindigkeit des Transportbandes | Anschaffungskosten der optischen Komponenten |
|---|---|---|
| Beispiel 1 | bis zu 15 m pro min. | < 500k € |
| Vergleichsbeispiel 2 | < 10m pro min. | >1000k € |

Die erfindungsgemäße Laservorrichtung (1) ermöglicht eine entscheidende Geschwindigkeitserhöhung des Transportbandes (5). Bei dem in-line mit der Laserbearbeitung verlaufenden Sputteringprozess werden Transportgeschwindigkeiten von 10 m pro Minute erreicht. Bei der anschließenden Bearbeitung der Glassubstrate (7) mit der nach dem Stand der Technik bekannten Laservorrichtung wird die Geschwindigkeit des Sputteringprozesses nicht erreicht, wodurch die Substrate zwischengelagert werden müssen und nicht direkt in-line weiterbearbeitet werden können. Die erfindungsgemäße Laservorrichtung (1) beschleunigt die Laserbearbeitung dahingehend, dass eine direkte Weiterbearbeitung der Glassubstrate (7) ohne Zwischenspeicherung möglich ist. Der komplette Produktionsprozess wird dadurch beschleunigt, was zu einer Senkung der Produktionskosten führt. Ferner verfügt die erfindungsgemäße Laservorrichtung (1) über einen wesentlich einfacheren Aufbau verglichen mit der komplexen optischen Anordnung der nach dem Stand der Technik bekannten Laservorrichtung. Wie in Tabelle 1 zu erkennen, können so die Anschaffungskosten der optischen Komponenten im Vergleich zur bekannten Laservorrichtung um insgesamt mehr als 50 Prozent verringert werden. Des Weiteren ermöglicht die erfindungsgemäße Laservorrichtung (1) eine einfache Justierung der optischen Anordnungen (3), da diese alternierend auf den Brücken (4) montiert sind und sich somit nicht gegenseitig behindern und unabhängig voneinander verschoben werden können.

### Bezugszeichenliste

- 1: Laservorrichtung
- 2: Laserquellen
- 3: optische Anordnungen
- 4: Brücken
- 4.1: erste Brücke
- 4.2: zweite Brücke
- 4.3: dritte Brücke
- 5: Transportband
- 6: Transportrichtung
- 7: Glassubstrat
- 8: Laserscanner
- 8.1: Polygonscanner
- 8.2: Galvanometerscanner
- 9: Linse
- 10: Blende
- 11: Laserstrahl
- 12: Laserlinie
- 13: Spiegel
- 14: Lichtleiter
- 15: Bearbeitungsbereiche
- 15.1: Bearbeitungsbereich der ersten Brücke
- 15.2: Bearbeitungsbereich der zweiten Brücke

## Patentansprüche

1. Laservorrichtung (1) zum Tempern von metallhaltigen oder metalloxidhaltigen Beschichtungen auf großflächigen Glassubstraten (7) mindestens umfassend:
a) mindestens eine Laserquelle (2),
b) mindestens zwei Brücken (4) überspannend ein Transportband (5) mit dem Glassubstrat (7),
wobei
- jede Brücke (4) mehrere optische Anordnungen (3) enthält, die alternierend auf den Brücken (4) angeordnet sind, **dadurch gekennzeichnet, dass**:
- jede optische Anordnung (3) eine Laserlinie (12) erzeugt und
- die Laserlinien (12) aller optischen Anordnungen (3) zusammen die gesamte Breite des Substrats (7) abdecken, wobei die Laserlinien (12) benachbarter optischer Anordnungen (3) einen Bereich mit einer Breite von 500 µm bis 1 cm gemeinsam abdecken.

2. Laservorrichtung (1) nach Anspruch 1, wobei eine erste Brücke (4.1) und eine zweite Brücke (4.2) über dem Transportband (5) angeordnet sind und die Anzahl der optischen Anordnungen (3) auf der ersten Brücke (4.1) n und auf der zweiten Brücke (4.2) n+1 oder umgekehrt beträgt.

3. Laservorrichtung (1) nach Anspruch 1, wobei die erste Brücke (4.1), die zweite Brücke (4.2) und eine dritte Brücke (4.3) über dem Transportband (5) angeordnet sind.

4. Laservorrichtung (1) nach einem der Ansprüche 1 bis 3, wobei die Anzahl der Laserquellen (2) mindestens der Anzahl der Brücken (4) entspricht.

5. Laservorrichtung (1) nach einem der Ansprüche 1 bis 4, wobei die optischen Anordnungen (3) mindestens einen Laserscanner (8), eine Linse (9) und eine Blende (10) umfassen.

6. Laservorrichtung (1) nach einem der Ansprüche 1 bis 5, wobei der Laserscanner (8) ein Polygonscanner oder ein Galvanometerscanner, bevorzugt ein Polygonscanner, ist.

7. Laservorrichtung (1) nach einem der Ansprüche 1 bis 6, wobei der Laserstrahl (11) über einen Spiegel (13) oder einen Lichtleiter (14) von der Laserquelle (2) zur optischen Anordnung (3) geleitet wird.

8. Laservorrichtung (1) nach einem der Ansprüche 1 bis 7, wobei der Abstand der optischen Anordnungen (3) zur Oberfläche des Glassubstrats (7) 10 cm bis 100 cm beträgt und die optischen Anordnungen (3) entlang der Brücken (4) quer zur Transportrichtung (6) des Transportbandes (5) um 1 cm bis 20 cm, bevorzugt 5 cm bis 15 cm, beweglich sind.

9. Laservorrichtung (1) nach einem der Ansprüche 1 bis 8, wobei die Laserlinien (12) benachbarter optischer Anordnungen (3) einen Bereich mit einer Breite von 0,1 cm bis 0,3 cm gemeinsam abdecken.

10. Laservorrichtung (1) nach einem der Ansprüche 1 bis 9, wobei die Brücken (4) einen Abstand von 20 cm bis 90 cm, bevorzugt 40 cm bis 60 cm zueinander haben.

11. Laservorrichtung (1) nach einem der Ansprüche 1 bis 10, wobei als Laserquelle (2) Dauerstrichlaser oder Pulslaser, bevorzugt Festkörperlaser, besonders bevorzugt Neodym-dotierte Yttrium-Aluminium-Granat-Laser (Nd:YAG-Laser), Ytterbiumdotierte Yttrium-Aluminium-Granat-Laser (Yb:YAG-Laser), Erbium-dotierte Yttrium-Aluminium-Granat-Laser (Er:YAG-Laser), Titan:Saphir-Laser oder Neodym-dotierte Yttrium-Vanadat-Laser (Nd:YVO₄-Laser) eingesetzt werden.

12. Verfahren zur kontinuierlichen Laserbearbeitung eines großflächigen Glassubstrats (7) mit einer Laservorrichtung (1) nach einem der Ansprüche 1 bis 11 umfassend
a) Justierung der optischen Anordnungen (3) so, dass sich die Laserlinien (12) benachbarter Optiken auf dem Glassubstrat (7) um 500 µm bis 1 cm überschneiden,
b) Synchronisieren der Geschwindigkeiten des Transportbandes (5) und der Laserscanner (8),
c) automatisierte Laserbearbeitung beim Durchlaufen der Glassubstrate (7) auf dem Transportband (5) unter den Brücken (4).

13. Verfahren nach Anspruch 12, wobei die Optiken (3) so justiert werden, dass sich die Laserlinien (12) benachbarter Optiken auf dem Glassubstrat (7) um 0,1 cm bis 0,3 cm überschneiden.

14. Verfahren nach Anspruch 12 oder 13, wobei das Transportband (5) sich mit einer Geschwindigkeit von 5m bis 15 m pro Minute, bevorzugt 9 m bis 11 m pro Minute bewegt.

15. Verwendung einer Laservorrichtung (1) nach einem der Ansprüche 1 bis 11 zur Bearbeitung von metallbeschichteten oder metalloxidbeschichteten Glassubstraten, besonders bevorzugt großflächigen Glassubstraten mit einer Breite von 1 m bis 6 m, bevorzugt mit einer Breite von mindestens 3 m.

## Claims

1. Laser device (1) for tempering metal-containing or metal-oxide-containing coatings on large-area glass substrates (7) comprising at least:
a) at least one laser source (2),
b) at least two bridges (4) spanning a conveyor belt (5) with the glass substrate (7),
wherein
- each bridge (4) contains a plurality of optical arrangements (3), which are alternatingly arranged on the bridges (4), **characterized in, that**:
- each optical arrangement (3) generates a laser line (12), and
- the laser lines (12) of all optical arrangements (3) together cover the entire width of the substrate (7), wherein the laser lines (12) of adjacent optical arrangements (3) together cover a region with a width of 500 urn to 1 cm.

2. Laser device (1) according to claim 1, wherein a first bridge (4.1) and a second bridge (4.2) are arranged over the conveyor belt (5) and the number of optical arrangements (3) on the first bridge (4.1) is n and on the second bridge (4.2) is n+1 or vice versa.

3. Laser device (1) according to claim 1, wherein the first bridge (4.1), the second bridge (4.2), and a third bridge (4.3) are arranged over the conveyor belt (5).

4. Laser device (1) according to one of claims 1 through 3, wherein the number of laser sources (2) corresponds to at least the number of the bridges (4).

5. Laser device (1) according to one of claims 1 through 4, wherein the optical arrangements (3) include at least one laser scanner (8), one lens (9), and one diaphragm (10).

6. Laser device (1) according to one of claims 1 through 5, wherein the laser scanner (8) is a polygonal scanner or a galvanometer scanner, preferably a polygonal scanner.

7. Laser device (1) according to one of claims 1 through 6, wherein the laser beam (11) is guided via a mirror (13) or a light guide (14) from the laser source (2) to the optical arrangement (3).

8. Laser device (1) according to one of claims 1 through 7, wherein the distance of optical arrangements (3) from the surface of the glass substrate (7) is 10 cm to 100 cm and the optical arrangements (3) are movable along the bridges (4) at right angles to the transport direction (6) of the conveyor belt (5) by 1 cm to 20 cm, preferably 5 cm to 15 cm.

9. Laser device (1) according to one of claims 1 through 8, wherein the laser lines (12) of adjacent optical arrangements (3) together cover a region with a width of 0.1 cm to 0.3 cm.

10. Laser device (1) according to one of claims 1 through 9, wherein the bridges (4) have a distance of 20 cm to 90 cm, preferably 40 cm to 60 cm between them.

11. Laser device (1) according to one of claims 1 through 10, wherein continuous-wave lasers or pulse lasers, preferably solid-state lasers, particularly preferably neodymium-doped yttrium-aluminum-granite lasers (Nd:YAG lasers), ytterbium-doped yttrium-aluminum-granite lasers (Yb:YAG lasers), erbium-doped yttrium-aluminum-granite lasers (Er:YAG lasers), titanium:sapphire lasers, or neodymium-doped yttrium-vanadate lasers (Nd:YVO₄ lasers) are used as a laser source (2).

12. Method for continuous laser processing of a large-area glass substrate (7) with a laser device (1) according to one of claims 1 through 11 comprising
a) adjustment of the optical arrangements (3), such that the laser lines (12) of adjacent optical systems overlap each other on the glass substrate (7) by 500 µm to 1 cm,
b) synchronization of the speeds of the conveyor belt (5) and the laser scanner (8),
c) automated laser processing during passage of the glass substrates (7) on the conveyor belt (5) under the bridges (4).

13. Method according to claim 12, wherein the optical system (3) is adjusted such that the laser lines (12) of adjacent optical systems overlap each other on the glass substrate (7) by 0.1 cm to 0.3 cm.

14. Method according to claim 12 or 13, wherein the conveyor belt (5) moves at a speed of 5 m to 15 m per minute, preferably 9 m to 11 m per minute.

15. Use of a laser device (1) according to one of claims 1 to 11 for processing metal-coated or metal-oxide-coated glass substrates, particularly preferably large-area glass substrates with a width of 1 m to 6 m, preferably with a width of mindestens 3 m.

## Revendications

1. Dispositif laser (1) pour de la trempe de revêtements métallisés ou contenant des oxydes métalliques sur des substrats de verre (7) à grande surface comprenant au moins :
a) au moins une source laser (2),
b) au moins deux ponts (4) enjambant une bande transporteuse (5) avec le substrat de verre (7), où
- chaque pont (4) contient plusieurs dispositifs optiques (3), qui sont disposées en alternance sur les ponts (4), **caractérisée en ce que** :
- chaque dispositif optique (3) crée une ligne laser (12) et
- les lignes laser (12) de tous les dispositif optiques (3) ensemble couvrent toute la largeur du substrat (7), où les lignes laser (12) de dispositifs optiques (3) adjacentes couvrent en commun une région d'une largeur de 500 µm à 1 cm.

2. Dispositif laser (1) selon la revendication 1, où un premier pont (4.1) et un deuxième pont (4.2) sont disposés sur la bande transporteuse (5) et le nombre des dispositifs optiques (3) sur le premier pont (4.1) est n et sur le deuxième pont (4.2) est n+1 ou vice versa.

3. Dispositif laser (1) selon la revendication 1, où le premier pont (4.1), le deuxième pont (4.2) et un troisième pont (4.3) sont disposés sur le tapis roulant (5).

4. Dispositif laser (1) selon l'une des revendications 1 à 3, où le nombre de sources laser correspond (2) au moins au nombre de ponts (4).

5. Dispositif laser (1) selon l'une des revendications 1 à 4, où les dispositifs optiques (3) comprennent au moins un balayeur laser (8), une lentille (9) et une ouverture (10).

6. Dispositif laser (1) selon l'une des revendications 1 à 5, où le balayeur laser (8) un balayeur à polygone ou un balayeur à galvanomètre, de préférence un balayeur à polygone.

7. Dispositif laser (1) selon l'une des revendications 1 à 6, où le faisceau laser (11) est dirigé par un miroir (13) ou une fibre optique (14) de la source laser (2) au dispositif optique (3).

8. Dispositif laser (1) selon l'une des revendications 1 à 7, où la distance entre des dispositifs optiques (3) à la surface du substrat de verre (7) est de 10 cm à 100 cm, et les dispositifs optiques (3) sont mobiles le long des ponts (4) transversales perpendiculaire à la direction de transport (6) de la bande de transport (5) de 1 cm à 20 cm, de préférence de 5 cm à 15 cm,

9. Dispositif laser (1) selon l'une des revendications 1 à 8, où les lignes laser (12) de dispositifs optique adjacents (3) couvrent ensemble une région d'une largeur de 0,1 cm à 0,3 cm.

10. Dispositif laser (1) selon l'une des revendications 1 à 9, où les ponts (4) ont une distance de 20 cm à 90 cm, de préférence 40 cm à 60 cm de distance.

11. Dispositif laser (1) selon l'une des revendications 1 à 10, où, des lasers (2) continus ou des lasers pulsés, de préférence des lasers à l'état solide, de façon particulièrement préférée des lasers au grenat d'yttrium et d'aluminium dopé au néodyme (lasers ND : YAG), des lasers au grenat d'yttrium et d'aluminium dopé à l'ytterbium (lasers YB : YAG), des lasers au grenat d'yttrium et d'aluminium dopé à l'erbium (lasers Er : YAG), des lasers titane-saphir ou des lasers au vanadate d'yttrium dopé au néodyme (laser ND : YVO₄) sont utilisés comme source laser.

12. Procédé d'usinage continu au laser d'un substrat en verre à grande surface (7) avec un dispositif à laser (1) selon l'une des revendications 1 à 11 comprenant :
a) réglage du dispositif optique (3) afin que les lignes laser (12) d'optiques adjacentes se chevauchent sur le substrat de verre (7) de 500 µm à 1 cm,
b) synchronisation de la vitesse de la bande transporteuse (5) et du balayeur laser (8),
c) usinage au laser automatisé lors du passage des substrats de verre (7) sur la bande transporteuse (5) sous les ponts (4).

13. Procédé selon la revendication 12, où les optiques (3) sont réglées de telle sorte que les lignes laser (12) des optiques adjacentes se chevauchent sur le substrat de verre (7) de 0,1 cm à 0,3 cm.

14. Procédé selon la revendication 12 ou 13, où la bande transporteuse (5) se déplace à une vitesse de 5 m à 15 m par minute, de préférence de 9 m à 11 m par minute.

15. Utilisation d'un dispositif à laser (1) selon l'une des revendications 1 à 11 pour l'usinage des substrats de verre revêtus d'oxydes métalliques ou métallisés, de façon particulièrement préférée des substrats de verre de grande surface avec une largeur de 1 m à 6 m, de préférence avec une largeur d'au moins 3 m.
